# EUROPEAN PATENT APPLICATION

(11) **EP 4 838 785 A1**
(43) Date of publication of application: **11.11.2026**
(21) Application number: 26174477.5
(22) Date of filing: 24.04.2026
(51) Int. Cl.: H03K 17/687, H10D 84/01

(54) **PULLDOWN SWITCH**

(30) Priority: 02.05.2025 US 202519196800
(71) Applicant: NXP USA, Inc., Austin, TX 78735 (US)
(72) Inventor: Amoroso, Antonio, 5656AG Eindhoven (NL)
(74) Representative: Krott, Michel

(57) **Abstract**

A pulldown switch includes a first NMOS transistor and a second NMOS transistor. A first current terminal and a body terminal the first NMOS transistor are coupled to a supply voltage rail. A second current terminal of the first NMOS transistor is coupled to a first current terminal of a second NMOS transistor. A second current terminal and a body terminal of the second NMOS transistor are coupled to an external IC terminal of the integrated circuit. The gates of both the first NMOS transistor and the second NMOS transistor are coupled to a control line.

## Description

### BACKGROUND OF THE INVENTION

### Field of the Invention

This invention relates to pulldown switches.

### Background

Some semiconductor devices utilize pulldown switches for selectively biasing external integrated circuit (IC) terminals (e.g., an external IC pins, pads, bumps, or balls) to a supply voltage rail.

### BRIEF DESCRIPTION OF THE DRAWINGS

The present invention may be better understood, and its numerous objects, features, and advantages made apparent to those skilled in the art by referencing the accompanying drawings.
Figure 1 is a circuit diagram of a prior art pulldown switch.
Figure 2 is a partial cutaway side view of a prior art integrated circuit.
Figure 3 is a circuit diagram of a prior art circuit.
Figure 4 is a partial cutaway side view of a prior art integrated circuit.
Figure 5 is a circuit diagram of circuitry including a pulldown switch according to some embodiments of the present invention.
Figure 6 is a partial cutaway side view of an integrated circuit according to some embodiments of the present invention.
Figure 7 is a graph showing a performance of the pulldown switch according to some embodiments of the present invention versus a prior art pulldown switch.
Figure 8 is a graph showing a performance of pulldown switches with different transistor width ratio sizes according to some embodiments of the present invention.
Figure 9 is a circuit diagram of circuitry including a pulldown switch according to some embodiments of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As described herein, a pulldown switch includes a first NMOS transistor and a second NMOS transistor. A first current terminal and a body terminal the first NMOS transistor are coupled to a supply voltage rail. A second current terminal of the first NMOS transistor is coupled to a first current terminal of a second NMOS transistor. A second current terminal and a body terminal of the second NMOS transistor are coupled to an external IC terminal of the integrated circuit. The gates of both the first NMOS transistor and the second NMOS transistor are coupled to a control line.

With some embodiments of such a configuration, the second NMOS transistor has lower reverse current capacity than the first NMOS transistor which may provide for a lower total reverse current capacity of the pulldown switch than with a pulldown switch that includes only the first NMOS transistor.

Integrated circuits may include external IC terminals that are coupled to other integrated circuits or electrical devices when implemented in a system. At certain times during the operation of an integrated circuit, at least some of these external IC circuit terminals may be at negative voltages or at voltages that are lower than the lowest supply voltage of the integrated circuit.

In some instances, additional features such as test features or protection features may be implemented with circuitry coupled to an external IC terminal of an integrated circuit. The operability of these features would require pulldown switches to bias the external IC terminal at a low supply voltage rail. It may be desirable for the pulldown switches not to interfere with the normal operations of the integrated circuit.

In other instances, pulldown switches may be implemented in circuitry for driving an output signal on an external IC terminal where the pulldown switch is used to bias the terminal at a low supply voltage to produce a low voltage state signal. However, pulldown switches may be used for other applications in an integrated circuit.

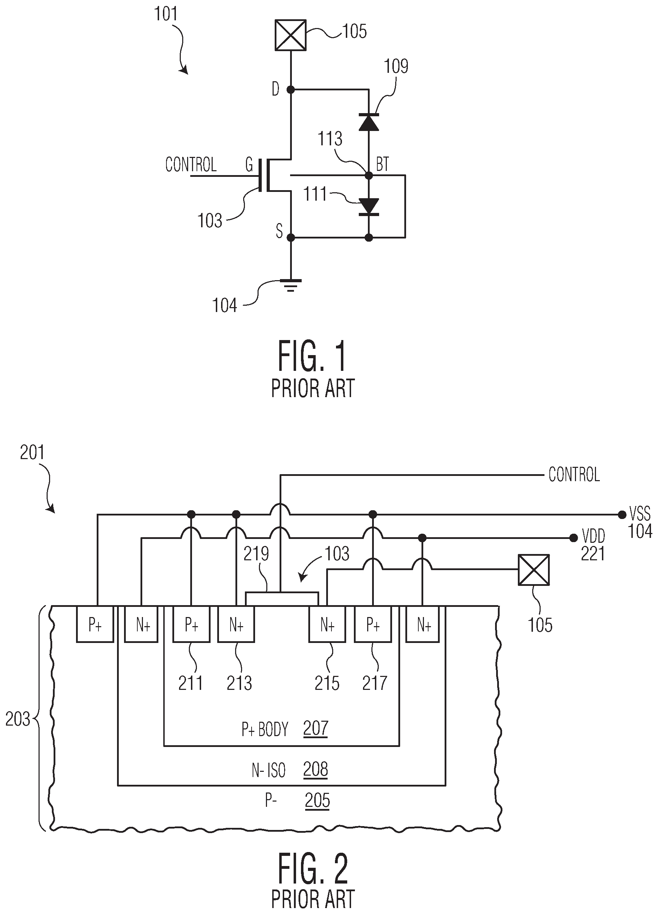

Figure 1 shows a circuit diagram of a prior art pulldown switch 101 implemented with an NMOS transistor 103. The source (S) and body terminal (BT) 113 of transistor 103 are connected to a VSS supply voltage rail 104 that provides a low supply voltage VSS to the integrated circuit of switch 101. The drain (D) of transistor 103 is connected to an external IC terminal 105. The gate of transistor 103 is connected to a control signal line that is asserted to make transistor 103 conductive to bias terminal 105 at the voltage of rail 104. Diodes 109 and 111 are internal to transistor 103. Diode 109 represents the diode formed from the body region and drain region of transistor 103. Diode 111 represents the diode formed from the body region and source region of transistor 103.

Figure 2 is a partial cutaway side view of an integrated circuit 201 that includes NMOS transistor 103. Integrated circuit 201 includes a substrate 203 that includes a substrate region 205 having a P-type conductivity doping. Transistor 103 includes a body region 207 having a P-type doping and includes a P-type body contact regions 211 and 217 that serve as the body contact region and are connected to the VSS supply voltage rail 104. An N-type isolation tub 208 substrate electrically isolates body region 207 from substrate region 205 for noise suppression. Tub 208 includes N-type contact regions of a higher N-type doping concentration (N+) that are connected to VDD supply voltage rail 221. Transistor 103 includes an N-type source region 213 connected to VSS rail 104, an N-type drain region 215 connected to terminal 105, and a gate 219 connected to the control line.

During some operating conditions, the voltage of terminal 105 may drop below the voltage of VSS rail 104. Even if switch 101 is intended to be nonconductive wherein the control signal is not asserted, reverse current can flow through transistor 103, especially where the voltage of terminal 105 drops below the supply voltage of VSS by the voltage threshold of transistor 103 (e.g., approximately .3V). For example, referring back to Figure 1, if terminal 105 is at a voltage below the voltage of rail 104 by at least a voltage threshold of transistor 103 (assuming that CONTROL is at a non-asserted voltage of VSS), NMOS transistor 103 will become conductive to conduct reverse current from its source (S) to its drain (D) through its channel region. Furthermore, because body terminal 113 of transistor 103 is connected to VSS rail 104, reverse current will also flow through the body terminal and through internal diode 109 to terminal 105.

This reverse current may cause an offset variation affecting parameter accuracy of a terminal, thereby degrading parameter accuracy of the integrated circuit. In some instances, the amount of reverse current increases with higher temperatures. The amount of reverse current may also increase as the voltage of terminal 105 becomes more negative. As such, under certain operating conditions, the reverse current flowing from VSS rail 104 through NMOS transistor 103 to terminal 105 may affect circuit effectiveness. In some cases, excessive reverse current may cause voltage issues with supply voltage levels and excessive power drain.

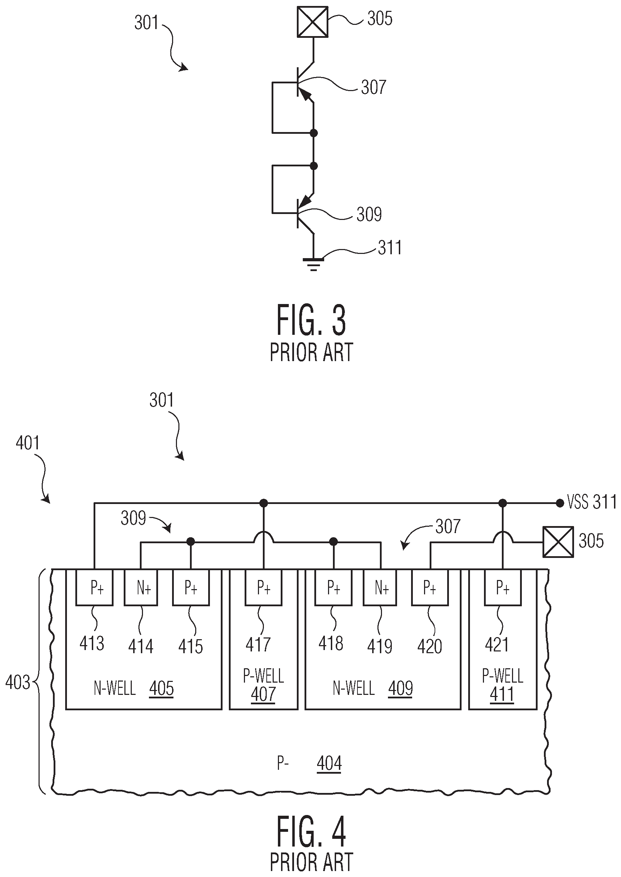

Figure 3 is a circuit diagram of a prior art ESD circuit 301 connected between an external IC terminal 305 and a VSS supply voltage rail 311. Circuit 301 includes two PNP transistors 309 and 307 connected in series at their emitters and bases. The collector of transistor 307 is connected to terminal 305 and the collector of transistor 309 is connected to VSS rail 311.

Figure 4 is a partial cutaway side view of integrated circuit 401 that includes circuit 301. Integrated circuit 401 includes substrate 403. Substrate 403 includes a P-type substrate region 404, P well 407, and P well 411. P-type region 413 and P-type region 415 serve as the collector and emitter, respectively, for transistor 309. N well 405 serves as the base region for transistor 309 and N-type region 414 serves as the base contact for transistor 309. P-type region 418 and P-type region 420 serve as the emitter and collector, respectively, for transistor 307, N well 409 serves as the base region for transistor 307 and N-type region 419 serves as the base contact for transistor 307. P-type region 417 serves as a contact region for P well 407 and is connected to VSS rail 311. P-type region 421 serves as a contact region for P well 411 and is connected to VSS rail 311.

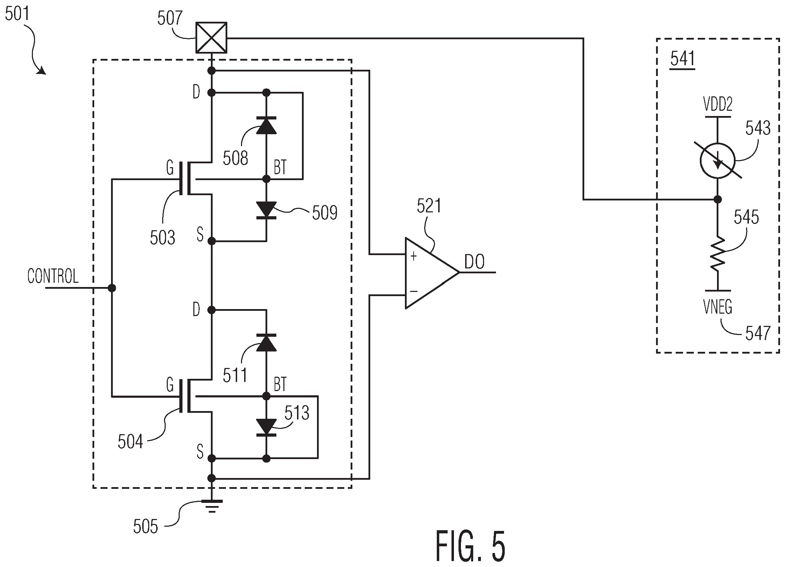

Figure 5 is a circuit diagram of a pulldown switch 501 and other circuitry according to some embodiments of the present invention. Pulldown switch 501 includes NMOS transistors 504 and 503 connected in series between external IC terminal 507 and VSS supply voltage rail 505. The source (S) of NMOS transistor 504 is connected to VSS supply voltage rail 505. The drain (D) of transistor 504 is connected to the source of transistor 503. The drain of transistor 503 is connected to external IC terminal 507. The gates (G) of transistors 503 and 504 are connected control line (CONTROL). The body terminal (BT) of transistor 503 is connected to terminal 507. The body terminal of transistor 504 is connected to rail 505. The control line provides a signal in an asserted high voltage state to place transistors 503 and 504 in a conductive state to bias terminal 507 at a supply voltage of VSS rail 505. In some embodiments, VSS supply voltage rail 505 is configured to provide a ground voltage, but in other embodiments, it may be configured to provide another supply voltage such as a negative voltage.

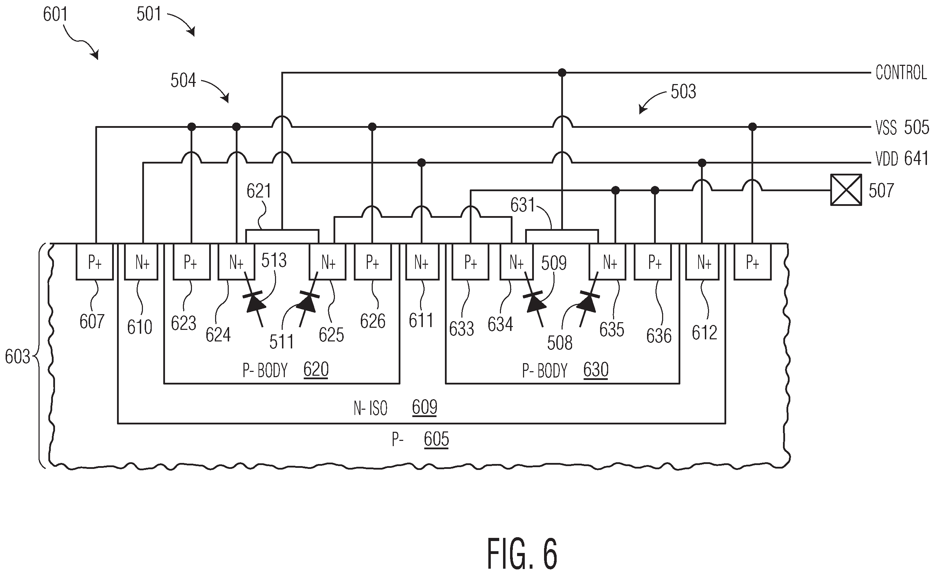

Diodes 508, and 509 are internal diodes of transistor 503 and diodes 511 and 513 are internal diodes of transistor 504. As shown in Figure 6, diode 508 represents the diode formed by the body region 630 and the drain region 635 of transistor 503, and diode 509 represents the diode formed by body region 630 and source region 634 of transistor 503. Diode 511 represents the diode formed by the body region 620 and the drain region 625 of transistor 504, and diode 513 represents the diode formed by body region 620 and source region 624 of transistor 504.

Figure 5 shows a comparator 521 that is used for test operations to determine whether external terminal 507 is at a particular voltage or not. Comparator 521 includes a noninverting input connected to terminal 507 and an inverting input connected to VSS rail 505. In other embodiments, the inverting input may be connected to another voltage source such as a reference voltage source, or it may be coupled to an adjustable reference source. The output of comparator (DO) provides an indication of whether terminal 507 is at a voltage above VSS. The CONTROL signal is at a low voltage state to enable comparator 521 to perform testing operations and at a high voltage state to pull terminal 507 to the voltage of rail 505 to disable the testing by comparator 521.

Terminal 507 is also connected to an external test circuit 541 (through a test lead (not shown) in contact with terminal 507 or through another type of testing structure). Circuit 541 is not located on the same integrated circuit as switch 501. In some embodiments, circuit 541 may be implemented in another integrated circuit (not shown) or may be implemented with multiple devices. Circuit 541 includes a resistor 545 and a variable current source 543 connected to each other. Current source 543 is connected to a positive voltage source VDD2. Resistor 545 is connected to a negative voltage source 547.

During testing, the current of current source 543 is varied to provide an adjustable test voltage at terminal 507. Comparator output DO provides an indication of whether terminal 507 above the voltage of the inverting input of comparator 521 during the test. If pulldown switch 501 where to allow a significant amount of reverse current from rail 505 to terminal 507 when terminal 507 is at a negative voltage, then the voltage at terminal 507 would be different from the intended test voltage in that the reverse current would flow through resistor 545 to increase the voltage drop across resistor 545. Accordingly, such a reverse current would affect the values indicated by DO and would therefore be detrimental to test parameter accuracy. However, as will be discussed later, the configuration of switch 501 limits its reverse current capacity when terminal 507 is at a voltage less than VSS. Other embodiments may include other types of test circuitry and/or perform other types of tests.

Figure 6 is a partial cutaway side view of an integrated circuit 601 that includes transistors 504 and 503 according to some embodiments. In the embodiment shown, a region designated with an "N" or a "P" indicates that the region has a net conductivity dopant concentration of either N-type dopants (e.g., arsenic, phosphorous) or P-type dopants (e.g., boron), respectively. A "+" next to the N or P indicates that the dopant concentration is relatively heavy and an "-" next to the N or P indicates that the dopant concentration is relatively lighter. Integrated circuit 601 includes a substrate 603 having a P-type semiconductor substrate layer region 605 that is made of a semiconductor material (e.g. silicon, silicon germanium, silicon carbon, gallium nitride) doped with P-type conductivity dopants (e.g., boron). In the embodiment shown, substrate 603 has a bulk semiconductor configuration, but may have other configurations in other embodiments such as a semiconductor on insulator (SOI) configuration.

In the embodiment shown transistors 503 and 504 have a planar configuration, but may have other configurations in other embodiments, e.g., a finFET configuration or an all-around gate configuration. Not shown in Figure 6 are the backend layers that include conductive interconnects separated by dielectric materials for interconnecting the semiconductor devices of integrated circuit 601 and for connecting the semiconductor devices with external IC terminals (e.g. 507) or integrated circuit 601. In some embodiments, at least some of the interconnects (e.g. supply voltage interconnects) may be located on the back side of substrate 603 (below substrate region 605 relative to the view shown in Figure 6). The symbols for internal diodes 508, 509, 511, and 513 are superimposed on the view of Figure 6.

Substrate region 605 includes contact region 607 that is connected to VSS rail 505 with conductive interconnects (not shown but represented symbolically in Figure 6) that are located in the backend layers of integrated circuit 601.

Transistor 504 includes a P-type body region 620 that includes P-type body contact regions 623 and 626 which are connected to VSS supply voltage rail 505 for biasing body region 620. P-type body contact regions 623 and 626 serve as the body terminal for transistor 504. Contact regions 623 and 626 are connected to VSS rail 505 through conductive interconnects (not shown but represented symbolically in Figure 6) located in backend layers (not shown) of integrated circuit 601. Rail 505 is connected to one or more external IC terminals (not shown) that are connected to an external VSS voltage source (not shown) when integrated circuit 601 is implemented in a system. N-type source region 624 and N-type drain region 625 serve as the source and drain, respectively, of transistor 504. Source region 624 is connected to VSS supply voltage rail 505 and drain region 625 is connected to source region 634 of transistor 503 through conductive interconnects (not shown but represented symbolically in Figure 6). Gate 621 is located over body region 620 and over a channel region of body region 620 that is located laterally between source region 624 and drain region 625.

Transistor 503 includes a P-type body region 630 that include P-type body contact regions 633 and 636 which are connected to the external IC terminal 507 for biasing body region 630. P-type body contact regions 633 and 636 serve as the body terminal for transistor 503. Contact regions 633 and 636 are connected to terminal 507 through conductive interconnects located in backend layers (not shown) of integrated circuit 601. Terminal 507 may be located on an exterior surface (not shown) of integrated circuit 601. N-type source region 634 and N-type drain region 635 serve as the source and drain, respectively, of transistor 503. Source region 634 is connected to drain region 625 of transistor 504 and drain region 635 is connected to terminal 507 through conductive interconnects (not shown but symbolically represented). Gate 631 is located over body region 630 and over a channel region of body region 630 that is located laterally between source region 634 and drain region 635.

Body region 630 of transistor 503 is substrate electrically isolated from body region 620 of transistor 504. As used herein, "substrate electrically isolated" means that there is no continuous conductive path in the substrate of same conductivity type doped regions (e.g., there is no path of P-type regions in the substrate between the two P-type body regions). As shown in Figure 6, body regions 620 and 630 are isolated by an N-type tub region 609 that includes N-type contact regions 610, 611, and 612 for biasing tub 609 by a VDD supply voltage rail 641 that may be connected to one or more VDD external IC terminals (not shown) or connected to an internal supply voltage source (not shown). In some embodiments, tub 609 is formed of a horizontal, N-type buried layer and vertical N-type regions that extend from the top surface of substrate 603 (relative to the view shown in Figure 6) to contact the buried N-type layer. However, other types of isolation structures may be utilized in other embodiments. For example, the body regions may be isolated by dielectric vias and/or buried dielectric layers (not shown), or the isolation structures may include a combination of dielectric structures and oppositely doped regions.

Isolation structures such as tub 609 allow for body regions 620 and 630 to be substrate electrically isolated from each other so as to allow for the body regions to be biased by two different sources without current flowing between the body regions. The isolation structures also substrate electrically isolates body regions 620 and 630 from other active regions of the integrated circuit.

Integrated circuits of other embodiments may have other structures, features, and/or arrangements in place of and/or in addition to what is shown in Figure 6. For example, an integrated circuit may include silicide structures, extension regions, side wall spacers, dielectric vias, and other buried layers. Furthermore, the regions may have other shapes than what is shown in Figure 6. Also in some embodiments, body region 620 would not be substrate electrically isolated from substrate region 605.

In other embodiments, integrated circuit 601 may include other semiconductor device such as other transistors, diodes, resistors, capacitors, etc. to implement other circuits (none shown). In some embodiments, integrated circuit 601 would include other pulldown switches (not shown) similar to switch 501 for other external IC terminals (not shown) of IC 601.

Referring back to Figure 5, external IC terminal 507 can be connected to a signal line or supply line from another integrated circuit or electrical device for implementation in a system. The other IC or electrical device may be located in the same IC package (not shown) as integrated circuit 601 or in other IC packages. Terminal 507 may carry communication signals, sensor signals, data signals, test signals, or other types of signals, which typically are at a voltage equal to or above the voltage of VSS during operation. Terminal 507 may carry input signals, output signals, or input and output signals. Integrated circuit 601 may be used in a number of different applications such as e.g., communications systems, auto electronics, industrial control systems, and data processing systems, etc..

During operation when the CONTROL signal is at a low voltage, the voltage of terminal 507 may drop to a lower voltage than VSS, which could cause a reverse current condition where current flows form rail 505 to terminal 507. As discussed with the prior art, such a reverse current condition may adversely affect the performance of the operations of the integrated circuit e.g., such as testing operations or affect supply voltage integrity or power consumption.

The addition of transistor 503 acts to significantly reduce the amount of reverse current flowing through switch 501 in these conditions. With the body terminal (BT) of transistor 503 being connected to terminal 507 and not connected to VSS rail 505, the amount of reverse current flowing through the source (S) of transistor 503 is reduced. Because the cathode of internal diode 509 is connected to the drain of transistor 504, current from the drain of transistor 504 is blocked from flowing through to the body terminal of transistor 503 to terminal 507. Thus, even though transistor 503 is in a conductive state where current flows from its source to its drain to terminal 507 during a reverse current condition, the amount of reverse current flowing through transistor 503 to terminal 507 is reduced. Accordingly, the amount of reverse current flowing from rail 505 to terminal 507 through switch 501 is reduced.

Furthermore, NMOS transistor 503 provides a secondary reverse current reduction effect for a pulldown switch. Because internal diode 509 blocks the flow of reverse current from the source of transistor 503, through the body terminal of transistor 503, to external IC terminal 507, the source to drain voltage drop across transistor 503 increases. Accordingly, the voltage at the drain of transistor 504 will be higher (i.e. less negative) than the voltage of terminal 507 in a reverse current condition, (and would be higher (i.e. less negative) than the drain voltage of transistor 103 for a similar reverse current condition). Accordingly, the drain to gate voltage of transistor 504 would be less than the drain to gate voltage of transistor 103. Because in a reverse voltage condition, the drains of NMOS transistors effectively become sources, a reduction in the drain to gate voltage of NMOS transistor 504 reduce the conductivity of transistor 504.

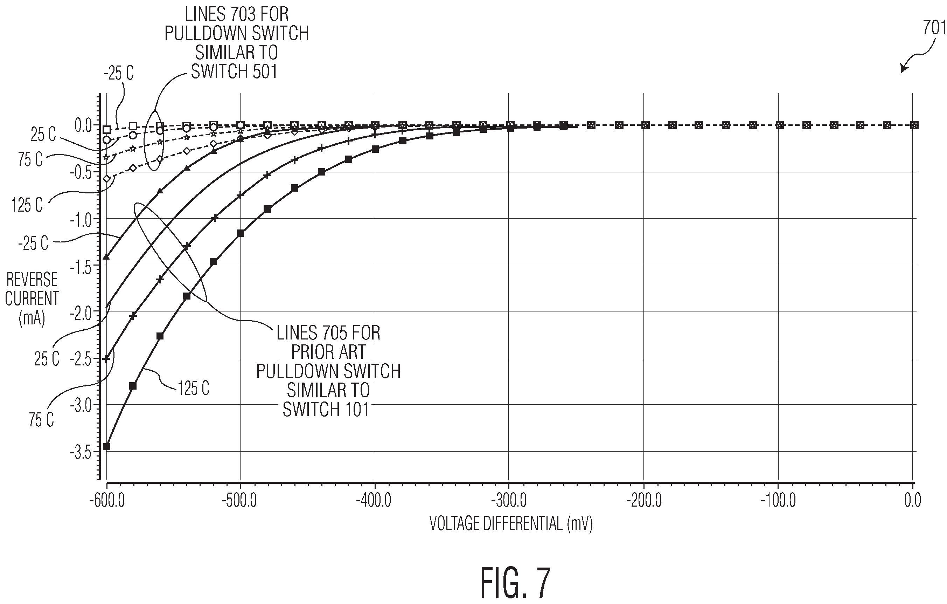

Figure 7 is a graph based on simulations showing a difference in reverse current at various temperatures between a pulldown switch similar to switch 501 of Figure 5 versus a prior art pulldown switch similar to switch 101 of Figure 1. The X axis of graph 701 represents a voltage differential (VOLTAGE DIFFERENTIAL) between a VSS rail (104, 505) and an external IC terminal (105, 507) where the voltage of the external IC terminal is below the voltage of the VSS rail in a range from 0V to -600 mV. Graph 701 includes a set of four lines 703 showing an amount of reverse current over the voltage range for a pulldown switch similar to switch 501 at temperatures of -25C, 25C, 75 C, and 125 C. Graph 701 includes a set of four lines 705 showing an amount of reverse current for a prior art pulldown similar to switch 101 of Figure 1 over the same voltage range and at the same four temperatures.

As shown in Figure 7, the amount of reverse current for all temperatures is negligible for voltage differentials having a magnitude of less than the threshold voltage of an NMOS transistor (approximately .3V). As the magnitude of the voltage differential increases (becomes more negative), the transistors of the pulldown switches begin to conduct reverse current. As shown in graph, the amount of reverse current increases with an increase in temperature where the higher temperatures produce a greater reverse current for the same voltage differential.

As shown in Figure 7, the addition of an NMOS transistor (similar to transistor 503) to a pulldown switch similar to switch 501 greatly reduces the reverse current capacity of the switch with respect to a prior art pulldown switch (similar to switch 101) at the four given temperatures. For example, at -25C with a voltage differential of -600mV, the pulldown switch similar to switch 501 conducts approximately -.045 mA of reverse current whereas the prior art switch similar to switch 101 conducts approximately -1.4 mA of reverse current. At 125 C with a voltage differential of -600mv, the pulldown switch similar to switch 501 conducts approximately -.575 mA of reverse current whereas the prior art pulldown switch similar to switch 101 conducts approximately -3.5 mA of reverse current. Other embodiments may provide a different amount of reverse current capacity reduction at similar temperatures and at similar voltage differentials.

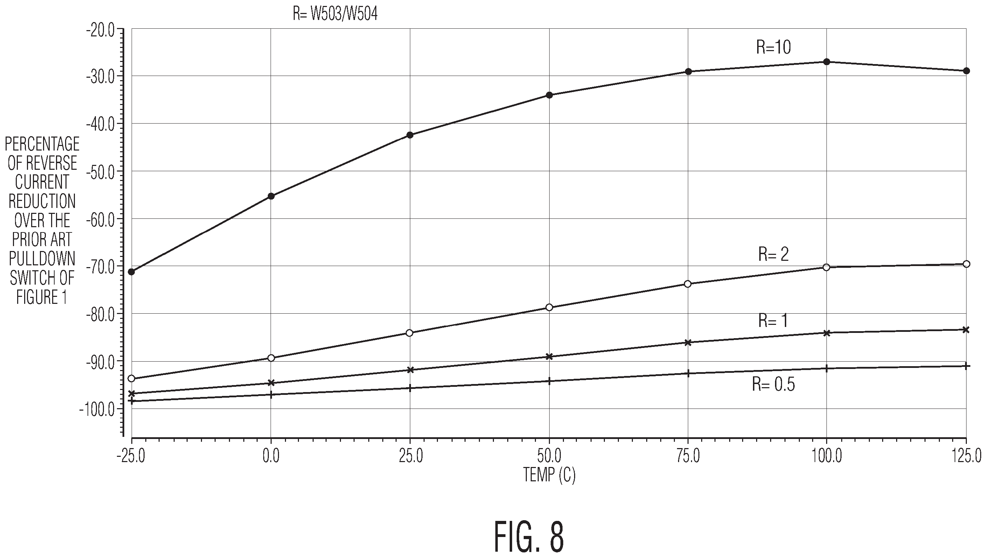

Figure 8 is a graph showing the percentage of reverse current reduction of switch 501 based on the ratio (R) of the channel width of transistor 503 (W503) to the channel width of transistor 504 (W504) versus prior art switch 101 over a temperature range. The values of the graph of Figure 8 were generated from simulations for a voltage differential of -600mV between voltage VSS and the voltage of terminal 507. As shown in Figure 8, the narrower the width of transistor 503 with respect to the width of transistor 504, the greater the reverse current reduction over the prior art switch. For example, at 75 C, an approximately 30 percent reduction in reverse current is achieved for a ratio R of 10. However, at a same temperature, an approximately 90 percent reduction is obtained for R=1. Other embodiments may produce other results. Accordingly, the ratios of the widths of the NMOS transistors of a pulldown switch can be varied to obtain a desired reduction in reverse current.

In some embodiments, reducing the width of transistor 503 with respect to the width of transistor 504 may affect the effectiveness of a pulldown switch to pulldown the voltage of the external IC terminal during normal operation when no reverse current condition is present.

Pulldown circuits may have other configurations and/or operate differentially in other embodiments. For example, referring back to Figure 5, a pulldown circuit may include resistors or diodes in at least some of the current paths. For example, a pull up circuit may include a resistor or diode in a path from a body terminal of transistor 503 to terminal 507 or a resistor or diode in the path from the body terminal of transistor 504 to VSS rail 505.

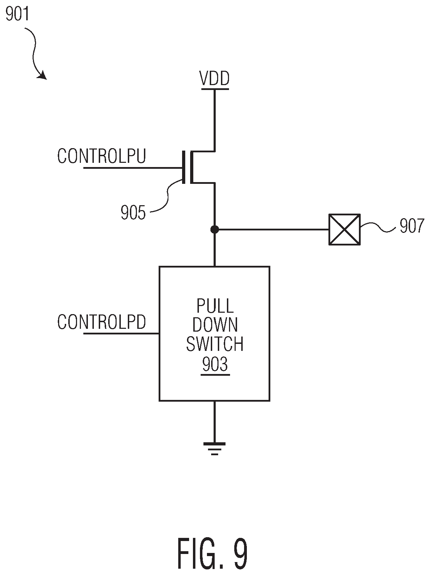

Figure 9 shows a circuit diagram of a driver circuit 901 according to some embodiments of the present invention. Driver circuit 901 includes a pullup PMOS transistor 905 connected to a VDD supply voltage rail and an external IC terminal 907 and includes a pulldown switch 903 connected to a VSS supply voltage rail and terminal 907. Pulldown switch 903 includes two NMOS transistors connected in series (not shown) and is similar to pulldown switch 501 of Figure 5. Control signals CONTROLPU and CONTROLPD are used to pull terminal 907 to VDD (when CONTROLPU and CONTROLPD are low), to pull terminal 907 to VSS (when CONTROLPU and CONTROLPD are high), or to disable the driver circuit 901 (when CONTROLPU is high and CONTROLPD is low).

In some embodiments, there may be times when terminal 907 is coupled to an external circuit that may be at a negative voltage when driver circuit 901 is disabled (when CONTROLPU is high and CONTROLPD is low). If pulldown switch 903 were to allow a significant amount of reverse current at this time, it may affect the voltage of VSS and/or may undesirably drain power from the integrated circuit of circuit 901. Accordingly, by providing a pulldown switch with a reduced reverse current capacity, an integrated circuit may consume less power and/or have better voltage regulation. Other driver circuits may have other configurations in other embodiments.

As described herein, providing a pulldown circuit with two NMOS transistor coupled in series between a supply voltage rail and an external IC terminal where the body terminal of one NMOS transistor is coupled to the supply voltage rail and the body terminal of the other NMOS transistor is coupled to the external IC terminal may provide for a pulldown circuit that conducts a significantly less amount of reverse current in reverse current conditions. Such a feature may improve the effectiveness and parameter accuracy of the integrated circuit operations, improve supply voltage integrity, and/or reduce power consumption during reverse current conditions.

A drain and a source are current terminals for a MOSFET, and a gate is a control terminal for a MOSFET. As used herein, two devices are coupled to each other either by being connected to each other or by being coupled through at least one other device in a current path. For example, referring to Figure 5, the drain of NMOS transistor 504 is coupled to the source of NMOS transistor 503 by being connected to the source of NMOS transistor 503. The drain of NMOS transistor 504 is coupled to terminal 507 through NMOS transistor 503.

In some embodiments, an integrated circuit (IC) includes an external IC terminal, a supply voltage rail configured to provide a supply voltage to the IC, and a first NMOS transistor including a first current terminal coupled to the supply voltage rail, a second current terminal, a gate coupled to a control line, and a body terminal coupled to the supply voltage rail. The integrated circuit includes a second NMOS transistor including a first current terminal coupled to the second current terminal of the first NMOS transistor, a second current terminal coupled to the external IC terminal, a gate coupled to the control line, and body terminal coupled to the external IC terminal.

In further embodiments of the integrated circuit, when the control line is placed at a conductive voltage to make the first NMOS transistor and the second NMOS transistor conductive to bias the external IC terminal, through the first NMOS transistor and through the second NMOS transistor, with the supply voltage rail.

In further embodiments of the integrated circuit, the control line is placed in a conductive voltage during an operating condition to disable other circuitry of the integrated circuit during operation.

In further embodiments of the integrated circuit, the other circuitry includes test circuitry coupled to the external IC terminal.

In further embodiments of the integrated circuit, the first NMOS transistor includes a first body region in a substrate of the integrated circuit that is biased by the supply voltage rail through the body terminal of the first NMOS transistor, the second NMOS transistor includes a second body region in the substrate that is biased by the external IC terminal through the body terminal of the second NMOS transistor, wherein the second body region is substrate electrically isolated from the first body region.

In further embodiments of the integrated circuit, the substrate includes at least one isolating structure for substrate electrically isolating the second body region from other active regions of the substrate.

In further embodiments of the integrated circuit, at least one of the at least one isolating structure is biased by a second supply voltage rail that is configured to provide a higher supply voltage than the supply voltage rail.

In further embodiments of the integrated circuit, the supply voltage rail is a ground rail.

In further embodiments of the integrated circuit, the external IC terminal is configured to convey a signal whose voltage, for at least some operating conditions, may fall below a voltage of the supply voltage rail.

In further embodiments of the integrated circuit, the first current terminal and the body terminal of the first NMOS transistor are connected to the supply voltage rail, the second current terminal of the first NMOS transistor is connected to first current terminal of the second NMOS transistor, and the second current terminal and the body terminal of the second NMOS transistor are connected to the external IC terminal.

In further embodiments of the integrated circuit, the second NMOS transistor has a different channel width than the first NMOS transistor.

In further embodiments of the integrated circuit, the first NMOS transistor and the second NMOS transistor are implemented in driver circuitry of the integrated circuit that includes a pullup transistor coupled to the external IC terminal.

In further embodiments of the integrated circuit, the second NMOS transistor includes an internal diode, wherein a body region of the second NMOS transistor serves as an anode region of the internal diode and a source region of the second NMOS transistor serves as a cathode of the internal diode, and the internal diode inhibits reverse current from flowing to the external IC terminal from the body terminal of the second NMOS transistor during a reverse current condition.

In further embodiments of the integrated circuit, during at least some reverse current conditions between the external IC terminal and the supply voltage rail, the second NMOS transistor has a lower reverse current capacity than the first NMOS transistor such that the second NMOS transistor limits an amount of reverse current through the first NMOS transistor.

In further embodiments of the integrated circuit, the supply voltage rail is a low supply voltage rail.

In other embodiments, an integrated circuit (IC) includes an external IC terminal, a supply voltage rail configured to provide a supply voltage to the IC, and a first NMOS transistor including a first current terminal connected to the supply voltage rail, a second current terminal, and a gate coupled to a control line. The integrated circuit includes a second NMOS transistor including a first current terminal connected to the second current terminal of the first NMOS transistor, a second current terminal connected to the external IC terminal, and a gate coupled to the control line. The first NMOS transistor includes a first body region in a substrate of the integrated circuit that is biased by the supply voltage rail, the second NMOS transistor includes a second body region in the substrate that is biased by the external IC terminal, wherein the second body region is substrate electrically isolated from the first body region.

In further embodiments of the integrated circuit, when the control line is placed at a conductive voltage to make the first NMOS transistor and the second NMOS transistor conductive to bias the external IC terminal, through the first NMOS transistor and through the second NMOS transistor, with the supply voltage rail.

In further embodiments of the integrated circuit, the second NMOS transistor includes an internal diode, wherein the second body region of the second NMOS transistor serves as the anode of the internal diode and a source region of the second NMOS transistor serves as a cathode of the internal diode, and the internal diode inhibits reverse current from flowing to the external current terminal from a body terminal of the second NMOS transistor during a reverse current condition.

In further embodiments of the integrated circuit, the supply voltage rail is a ground rail.

In further embodiments of the integrated circuit, during at least some reverse current conditions between the external IC terminal and the supply voltage rail, the second NMOS transistor has a lower reverse current capacity than the first NMOS transistor such that the second NMOS transistor limits an amount of reverse current through the first NMOS transistor.

Features specifically shown or described with respect to one embodiment set forth herein may be implemented in other embodiments set forth herein.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true spirit and scope of this invention.

## Claims

1. An integrated circuit (IC) comprising:
an external IC terminal;
a supply voltage rail configured to provide a supply voltage to the IC;
a first NMOS transistor including a first current terminal coupled to the supply voltage rail, a second current terminal, a gate coupled to a control line, and a body terminal coupled to the supply voltage rail;
a second NMOS transistor including a first current terminal coupled to the second current terminal of the first NMOS transistor, a second current terminal coupled to the external IC terminal, a gate coupled to the control line, and body terminal coupled to the external IC terminal.

2. The integrated circuit of claim 1, wherein when the control line is placed at a conductive voltage to make the first NMOS transistor and the second NMOS transistor conductive to bias the external IC terminal, through the first NMOS transistor and through the second NMOS transistor, with the supply voltage rail.

3. The integrated circuit of claim 2, wherein the control line is placed in a conductive voltage during an operating condition to disable other circuitry of the integrated circuit during operation.

4. The integrated circuit of claim 3, wherein the other circuitry includes test circuitry coupled to the external IC terminal.

5. The integrated circuit of any preceding claim, wherein the first NMOS transistor includes a first body region in a substrate of the integrated circuit that is biased by the supply voltage rail through the body terminal of the first NMOS transistor, the second NMOS transistor includes a second body region in the substrate that is biased by the external IC terminal through the body terminal of the second NMOS transistor, wherein the second body region is substrate electrically isolated from the first body region.

6. The integrated circuit of claim 5, wherein the substrate includes at least one isolating structure for substrate electrically isolating the second body region from other active regions of the substrate.

7. The integrated circuit of claim 6, wherein at least one of the at least one isolating structure is biased by a second supply voltage rail that is configured to provide a higher supply voltage than the supply voltage rail.

8. The integrated circuit of any preceding claim, wherein the supply voltage rail is a ground rail.

9. The integrated circuit of any preceding claim, wherein the external IC terminal is configured to convey a signal whose voltage, for at least some operating conditions, may fall below a voltage of the supply voltage rail.

10. The integrated circuit of any preceding claim, wherein the first current terminal and the body terminal of the first NMOS transistor are connected to the supply voltage rail, the second current terminal of the first NMOS transistor is connected to first current terminal of the second NMOS transistor, and the second current terminal and the body terminal of the second NMOS transistor are connected to the external IC terminal.

11. The integrated circuit of any preceding claim, wherein the second NMOS transistor has a different channel width than the first NMOS transistor.

12. The integrated circuit of any preceding claim, wherein the first NMOS transistor and the second NMOS transistor are implemented in driver circuitry of the integrated circuit that includes a pullup transistor coupled to the external IC terminal.

13. The integrated circuit of any preceding claim, wherein:
the second NMOS transistor includes an internal diode, wherein a body region of the second NMOS transistor serves as an anode region of the internal diode and a source region of the second NMOS transistor serves as a cathode of the internal diode;
the internal diode inhibits reverse current from flowing to the external IC terminal from the body terminal of the second NMOS transistor during a reverse current condition.

14. The integrated circuit of any preceding claim, wherein during at least some reverse current conditions between the external IC terminal and the supply voltage rail, the second NMOS transistor has a lower reverse current capacity than the first NMOS transistor such that the second NMOS transistor limits an amount of reverse current through the first NMOS transistor.

15. The integrated circuit of any preceding claim, wherein the supply voltage rail is a low supply voltage rail.
